Europäisches Patentamt

European Patent Office

Office européen des brevets

(11) Publication number: **0 127 401**
**B1**

(12) **EUROPEAN PATENT SPECIFICATION**

(45) Date of publication of patent specification: **17.08.88**

(51) Int. Cl.⁴: **H 01 L 31/02,** H 01 L 33/00

(21) Application number: **84303380.4**

(22) Date of filing: **17.05.84**

(54) **Electro-optical element package.**

(30) Priority: **31.05.83 JP 97628/83**

(43) Date of publication of application:
**05.12.84 Bulletin 84/49**

(45) Publication of the grant of the patent:
**17.08.88 Bulletin 88/33**

(84) Designated Contracting States:
**DE FR GB NL SE**

(56) References cited:
**WO-A-82/02800**
**US-A-4 233 614**

**Patent Abstracts of Japan vol. 4, no. 44, 5. April 1980 page 19E5 & JP-A-55-13963**

(73) Proprietor: **SUMITOMO ELECTRIC INDUSTRIES LIMITED**
**No. 15, Kitahama 5-chome Higashi-ku**
**Osaka-shi Osaka 541 (JP)**

(72) Inventor: **Nishizawa, Hideaki**
**1-3 Shimaya 1-chome**
**Konohana-ku Osaka (JP)**

(74) Representative: **Jennings, Roy Alfred et al**
**GILL JENNINGS & EVERY 53-64 Chancery Lane**
**London WC2A 1HN (GB)**

EP 0 127 401 B1

Courier Press, Leamington Spa, England.

## Description

This invention relates to a package or mounting assembly for an electro-optical element such as a light emitting diode or photodiode.

The principal technical requirements called for in a package for receiving an electro-optical element such as a light emitting diode or photodiode are: (1) that the package permits light to be transmitted to or from the element; (2) that electrodes can be connected to the element by providing wiring on the element by die-bonding or wire-bonding; and (3) that the package can be hermetically sealed in order to guard against environmental changes and preserve reliability.

Various constructions for such packages are known, and several examples of known packages including, for the purposes of this description, a photodiode will now be described with reference to Figures 1 to 5 of the accompanying drawings, in which:-

Figures 1a and 1b are cross sectional views showing two slightly different examples of a first type of known package;

Figures 2, 3 and 4 are views similar to Figures 1a and 1b but showing examples of three further types of known package; and,

Figures 5a and 5b are cross sectional views of a portion of the example shown in Figure 2, drawn to an enlarged scale, illustrating a drawback of this type of package.

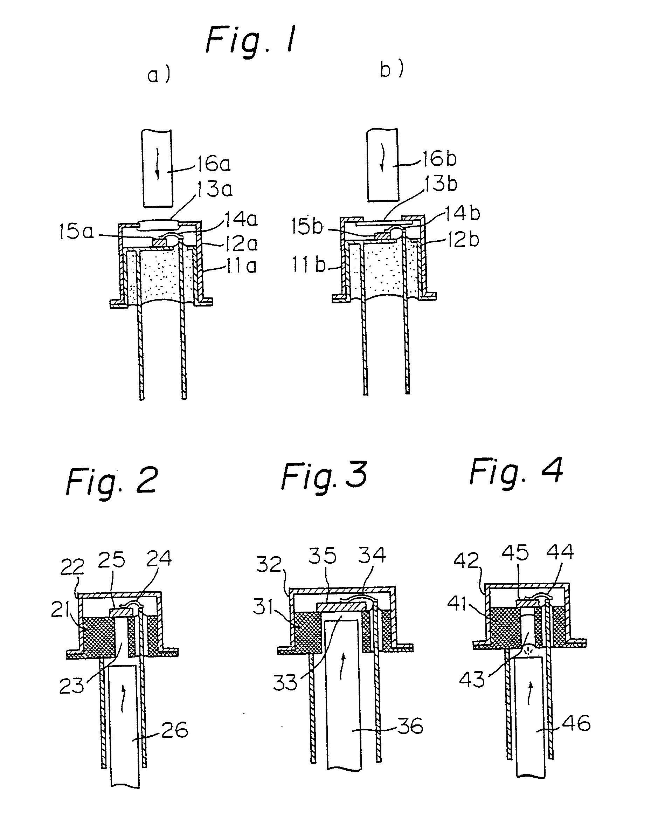

In the first type of electro-optical element package shown in Figures 1a and 1b, conventional TO-18 type package bodies 11a, 11b have photodiodes 15a, 15b respectively die-bonded thereto by means of epoxy resin, eutectic solder, or the like. Au wires 14a, 14b are bonded to the photodiodes 15a, 15b respectively, and caps 12a, 12b having light permeable windows formed of Kovar glass 13a and a sapphire plate 13b respectively are welded to the bodies 11a, 1b as shown. Both of these known packages have the drawback that there can be a lack of dimensional precision between the caps 12a, 12b and the bodies 11a, 11b in their manufacture, and also that the presence of the Au wires 14a, 14b on the photodiodes make the distance between the upper surface of the photodiode 15a, 15b and the window 13a, 13b great which, as a result, impairs the optical coupling efficiency between the photodiode 15a, 15b and an optical fibre 16a, 16b for conducting light for transmission to the photodiode.

An example of a second type of electro-optical element package, which is different from the first type with respect to the light receiving system, is shown in Figure 2. In this example, a conventional TO-46 type package body 21 provided with a through opening 23 has a photodiode 25 die-bonded to it coaxially with the through opening 23. Au wire 24 is bonded to the photodiode 25, and a cap 22 is welded to the body 21 to provide the construction as shown. As in the first example, however, this construction also has the drawback that the distance between the photodiode 25 and the optical fibre 26, which transmits to the photodiode through the opening 23, is relatively large so that the optical coupling efficiency is impaired.

Figure 3 shows an example of a third type of electro-optical element package in which this particular drawback of the first and second types is eliminated. This third example differs from the second in that the through opening 33 in the body 31 is made wide enough to receive the optical fibre 36 so that the distance between the photodiode 35 and the optical fibre 36 can be shortened. In this example, however, it is possible for the optical fibre 36 to contact and damage the photodiode 35 when the optical fibre is inserted into the body 31 and, as a result, the construction has the disadvantage that the assembly of the components is very difficult.

Figure 4 shows an example of a fourth type of package which is the same as that shown in Figure 2 except that the through opening in the body 41 is sealed by Kovar glass 43. Consequently this fourth type of package also has the same drawback as described above in connection with the second type.

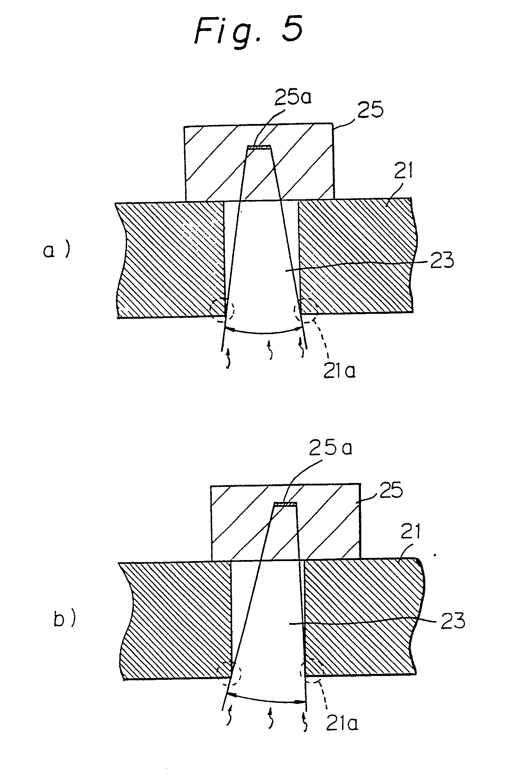

Further drawbacks common to the second and fourth types of known electro-optical element packages will now be described with reference to Figure 5 which shows the light receiving region of the second example. In the construction shown in Figure 5a, a photodiode 25 including a light sensitive area 25a is die-bonded to the upper surface of a metal or ceramic substrate 21. The angular aperture for the incoming light is limited by the edge 21a of the opening 23 through the substrate 21. Figure 5b shows the condition when the photodiode 25 moves out of place at the time of die-bonding and the angular aperture for the incoming light is thus substantially limited on one side thereof. It will be appreciated, therefore, that in these examples a rigidly precise die-bonding technology is required. Also, in order to increase the above-mentioned angular aperture, it is preferable that the thickness of the substrate 21 is lessened and the cross-sectional area of the through opening 23 increased as much as possible. However, when the thickness of the substrate 21 is reduced, the package itself can present a problem with respect to strength, and when the cross-sectional area of the through opening 23 is increased, there is the problem that the size of the photodiode 25 has to be increased accordingly. Furthermore, in these examples, there is the problem that ceramics or metal have to be machined to form the through opening 23, which is a mechanical process, the precision of which imposes limitations on the construction of the package.

Patent Abstracts of Japan, volume 4, No. 44, April 1980, page 19E5 discloses an electro-optical element package comprising a transparent substrate on which an electro-optical element is mounted, electrical connections to the element, and a window for the transmission of light to or from the element and an electrode pad formed on the substrate, the electro-optical element being bonded on top of the electrode pad over an opening in the pad so that light is transmitted to or from the element through the transparent substrate and the opening in the electrode pad. The transparent substrate is mounted on the substrate of the package.

A principal object of the present invention is to provide a novel package for an electro-optical element which does not suffer from the drawbacks inherent in the known packages described above, and to this end, according to the invention, such an electro-optical element package is characterised in that the substrate is made of sapphire and is the substrate of the package.

This construction enables a package to be made in which the optical coupling efficiency between the electro-optical element and the optical fibre can be increased substantially without weakening the package or requiring the size of the electro-optical element to be increased. Also, there is more freedom permitted in the design of the package, and the components of the package can be manufactured and assembled easily and accurately.

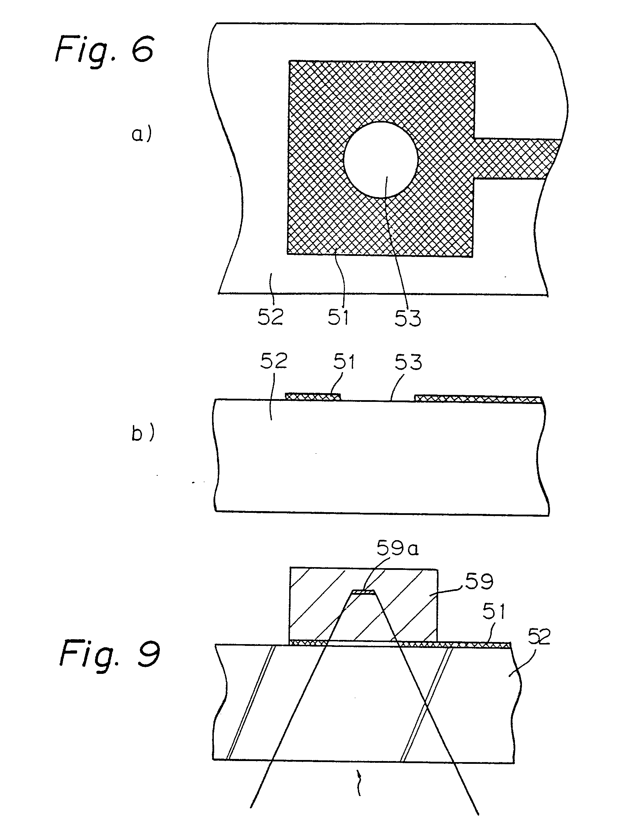

A preferred form of the package in accordance with the invention will now be described with reference to Figures 6 to 9 of the accompanying drawings, in which:-

Figures 6a and 6b are partial top plan and side elevational views respectively of two of the main components of the package;

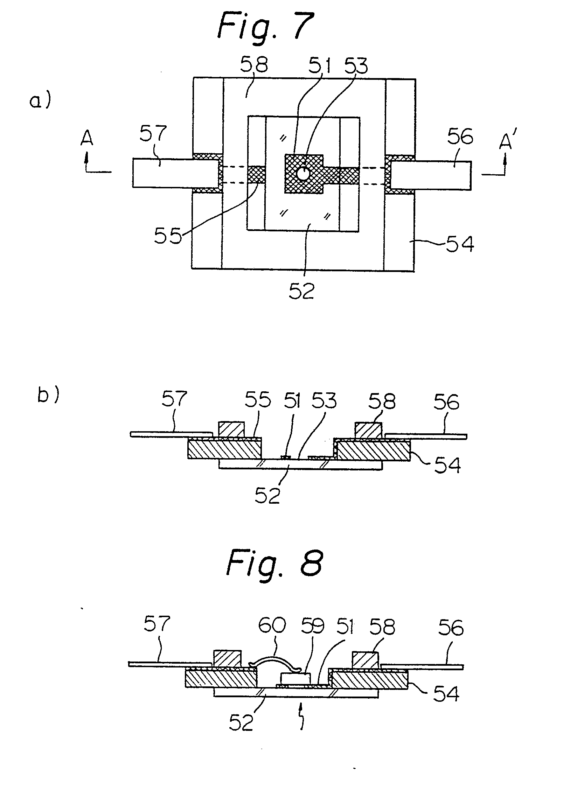

Figure 7a is a top plan view of the package in a partly assembled-state;

Figure 7b is a sectional view taken along the line A-A' in Figure 7a;

Figure 8 is a side elevational view of the almost completed package incorporating a photodiode; and,

Figure 9 is a cross sectional view of a portion of the package and showing the basic principle of its construction.

Figures 6a and 6b show part of a metallic pad 51, for die-bonding an electro-optical element, formed on the upper surface of a sapphire substrate 52. The pad 51 has a window 53 therein, the shape of which is circular, but may be rectangular or any other desired shape. The pad 51 forms an electrode, and is preferably formed on the sapphire substrate as a metallic layer by a photolithographic technique.

Figures 7 and 8 illustrate the construction of an embodiment of the present invention in which a transparent sapphire substrate 52 has a rectangular or other ring-like peripheral member 54 bonded to its upper surface. The peripheral member 54 may be made of ceramic material, such as alumina, and may be bonded to the substrate 52 by brazing. A metallic electrode pad 51 including a window 53 therein is formed on the top of the substrate 52 in the area surrounded by the peripheral member 54, and is also formed across the upper surface of the peripheral member 54 to provide an electrically conducting path. Another metallic layer 55 is formed on the peripheral member 54 on the opposite side of the package to form the other electrode. The metallic layers 51, 55 may be formed at the same time as each other by photolithographic means. Leads 56, 57 are bonded to the metallic layers 51, 55 respectively to form the electrical connections to the package. Another peripheral member 58 formed of ceramic material such as alumina is overlapped on and resin-bonded to the first peripheral member 54. An electro-optical element, in this case a photodiode 59, is die-bonded to the pad 51 over the window 53 by the use of a ring solder, such as AuSn eutectic mixture for example, and a lead 60, e.g. of Au wire, is wire-bonded to the photodiode 59 and to the second electrode formed by the metallic layer 55. For hermetically sealing the package it is only necessary to fix an alumina cap on to the alumina peripheral member 58.

A package designed in accordance with the present invention makes it easy to couple the electro-optical element, i.e. the photodiode 59 in the above case, and the optical fibre, as will now be explained with reference to Figures 5a and 9 which respectively show cross-sections of the light receiving portions of a known package and the embodiment of the invention described above. The substrate 21 of the known package is formed of opaque material, such as metal or ceramic, whereas the substrate 52 of the package in accordance with the invention is formed of transparent sapphire glass. Therefore, in the package in accordance with the invention, the angular aperture for the incoming light can be much wider as shown in Figure 9, with the result that the optical coupling efficiency between the optical fibre and the element is substantially improved. Also, since transparent sapphire glass is employed to form the substrate, the thickness of the substrate is not subjected to any limitation in order to obtain a wide angular aperture and thus, the package can be designed more freely than in the case of the previously known types of package.

As to the process for forming the light receiving portion, in the known packages including a through opening in the substrate, machining is required. On the other hand, in the package according to the invention, the windowed pad to which the electro-optical element is die-bonded may be formed by photolithography and fine processing is possible without requiring any machining process. This enables more precise and easy working of the package without substantially increasing the size of the optical element.

In the foregoing description the specific embodiment has been described with reference to a photodiode, but it should be apparent that the invention can be applied equally as well to light emitting diodes and all other electro-optical elements which receive or emit light.

## Claims

1. An electro-optical element package comprising a transparent substrate (52) on which an electro-optical element (59) is mounted, electrical connections (51, 60) to the element, and a window (53) for the transmission of light to or from the element and an electrode pad (51) formed on the substrate, the electro-optical element (59) being bonded on top of the electrode pad over an opening (53) in the pad so that light is transmitted to or from the element (59) throuqh the transparent substrate (52) and the opening (53) in the electrode pad (51) characterised in that the substrate (52) is made of sapphire and is the substrate of the package.

2. A package according to claim 1, in which the electrode pad (51) is a metallic layer formed by photolithography.

3. A package according to claim 1 or claim 2, further characterised by a peripheral member (54) made of ceramic material bonded on top of the substrate (52) surrounding the electro-optical element (59), and the electrode pad (51) extends over the peripheral member (54).

4. A package according to claim 3, further characterised by a second ring like peripheral member (58) formed of ceramic material overlapping and bonded on top of the first peripheral member (54) and a cap welded to the second peripheral member (58) to complete a sealed chamber containing the electro-optical element (59).

## Patentansprüche

1. Elektrooptisches Bauelement, bestehend aus einem transparenten Substrat (52), auf welchem ein elektrooptisches Element (59) befestigt ist, an dem betreffenden Element angeschlossenen elektrischen Anschlüssen (51, 60), einem dem Lichtdurchlaß in Richtung des Elementes und von demselben durchlässigen Fenster (53) sowie einem auf dem Substrat vorgesehenen Elektrodenanschluß (51), wobei das elektrooptische Element (59) oberhalb einer innerhalb des Anschlusses vorgesehenen Öffnung (53) derart an dem Elektrodenanschluß befestigt ist, daß das Licht durch das transparente Substrat (52) und die innerhalb des Elektronenanschlusses (51) vorgesehene Öffnung (53) in Richtung des Elementes (59) oder von demselben weggeleitet ist, dadurch gekennzeichnet, daß das Substrat (52) aus Saphir besteht und dabei das Substrat des Bauelementes bildet.

2. Bauelement nach Anspruch 1, dadurch gekennzeichnet, daß der Elektrodenanschluß (51) eine photolithographisch hergestellte Metalschicht ist.

3. Bauelement nach Anspruch 1 oder 2, dadurch gekennzeichnet, daß um das elektrooptische Element (59) zusätzlich ein aus einem Keramikmaterial bestehendes peripheres Element (54) auf der Oberfläche des Substrats (52) befestigt ist, und daß der Elektrodenanschluß (51) sich über das periphere Element (54) erstreckt.

4. Bauelement nach Anspruch 3, dadurch gekennzeichnet, daß auf die obere Fläche des ersten peripheren Elementes (54) ein zweites ringförmiges peripheres Element (58) aus Keramikmaterial überlappend befestigt ist, und daß auf das zweite periphere Element (58) eine Kappe festgeschweißt ist, welche eine abgeschlossene Kammer für das elektrooptische Element (59) bildet.

## Revendications

1. Boîtier pour composant électro-optique comprenant un substrat transparent (52) sur lequel est monté un composant électro-optique (59), des connexions électriques (51, 60) vers le composant, et une fenêtre (53) pour la transmission de lumière vers ou du composant et un plot d'électrode (51) formé sur le substrat, le composant électro-optique (59) étant relié au sommet du plot d'électrode par une ouverture (53) dans le plot de manière que la lumière soit transmise vers ou du composant (59) à travers le substrat transparent (52) et l'ouverture (53) dans le plot (51) d'électrode, caractérisé en ce que le substrat (52) est fait en saphir et est le substrat du boîtier.

2. Boîtier selon la revendication 1, où le plot d'électrode (51) est une couche en métal forméepar photolithographie.

3. Boîtier selon la revendication 1 ou la revendication 2, caractérisé de plus par un organe périphérique (54) fait en une matière cèramique, relié au sommet du substrat (52) entourant le composant électro-optique (59) et le plot d'électrode (51) s'étend sur l'organe périphérique (54).

4. Boîtier selon la revendication 3, caractérisé de plus par un second organe périphérique annulaire (58) formé en une matière céramique recouvrant le sommet du premier organe périphérique (54) et lui étant relié, et un capuchon soudé au second organe périphèrique (58) pour former une chambre hermétique contenant le composant électro-optique.

# *Fig. 1*

a )   b )

16a
13a
15a   14a
12a
11a

16b
13b
15b   14b
12b
11b

# *Fig. 2*   # *Fig. 3*   # *Fig. 4*

22  25  24
21
23
26

32  35  34
31
33
36

42  45  44
41
43
46

1

# Fig. 5

a)

b)

*Fig. 6*

a)

52  51  53

b)

52  51  53

59a

59

51

52

*Fig. 9*

# Fig. 7

a)

b)

# Fig. 8